# EUROPEAN PATENT APPLICATION

(11) **EP 4 760 392 A1**
(43) Date of publication of application: **17.06.2026**
(21) Application number: 25199381.2
(22) Date of filing: 01.09.2025
(51) Int. Cl.: G03F 7/00

(54) **TRANSMISSIVE EUV LITHOGRAPHY DEVICE**

(30) Priority: 16.12.2024 KR 20240186691
(71) Applicant: E-SOL, Inc., Hwaseong-si, Gyeonggi-do 18487 (KR)
(72) Inventor: LEE, Dong Gun, 18440 Hwaseong-si, Gyeonggi-do (KR)
(74) Representative: M. Zardi & Co S.A.

(57) **Abstract**

The present invention relates to a transmissive EUV lithography device, comprising, in a lithography device: an EUV light source; a first membrane-type diffractive optical element that transmits EUV light output from the EUV light source to provide illumination light; a transmissive EUV mask that generates a pattern light to be patterned on a wafer with the EUV light transmitted through the first membrane-type diffractive optical element; and a second membrane-type diffractive optical element for exposing the wafer to the pattern light generated from the transmissive EUV mask. In addition, the EUV light source is composed of an EUV light source with a wavelength of 13.5 nm generated by a plasma reaction through a Lithium or lithium alloy target. In addition, the first membrane-type diffractive optical element and the second membrane-type diffractive optical element are zone-plate lenses.

## Description

### BACKGROUND OF THE DISCLOSURE

### Cross Reference to Related Application of the Disclosure

The present application claims the benefit of Korean Patent Application No. 10-2024-0186691 filed in the Korean Intellectual Property Office on DEC 16, 2024, the entire contents of which are incorporated herein by reference.

### Field of the Disclosure

The present invention relates to a transmissive EUV lithography device, and more particularly, to a transmissive EUV lithography device that has high transmittance and accordingly, very high light efficiency.

### Background of the Related Art

Illumination systems for EUV projection lithography are disclosed in US 5,361,292, DE 103 17 667 A1, US 2010/0231882 A1, and US 6,507,440 B1, among others.

A facet mirror, in which the partial beam of each facet is transferred in such a way that it overlaps in the object field, and which is arranged such that the position on the facet mirror of each facet, i.e., the spatial position of that facet on the facet mirror, predefines the illumination direction, and at the same time, the edge contour of the impact of the facet mirror predefines the field-shaped image of the object field, is known as a so-called specular reflector, for example, from DE 103 17 667 A1 and US 2010/0231882 A1.

Hereinafter, such a facet mirror is referred to as a specular facet mirror, and the individual facets of such a facet mirror are also referred to as specular facets. In the case of the specular reflectors according to DE 103 17 667 A1 and US 2010/0231882 A1, each individual facet is also composed of a plurality of individual micro-mirrors.

Recently, EUV photolithography equipment for manufacturing semiconductor devices using EUV light with a wavelength of 13.5 nm has been fully introduced into the semiconductor manufacturing process. The EUV photolithography equipment is advantageous for the miniaturization of devices by using a shorter wavelength compared to the conventional ArF photolithography equipment with a 193 nm wavelength.

In the future, it is expected that EUV photolithography equipment with a larger NA (Numerical Aperture) of 0.55 than the current 0.33 NA will be introduced, enabling the formation of even smaller miniaturized patterns.

The EUV photolithography equipment currently being applied in the industry constitutes an optical system with an EUV light source generated from laser plasma and mirrors with a multilayer film that reflects EUV light. And for the formation of fine patterns, an EUV mask is used as a master mask.

The EUV mask has a different structure from that in the conventional ArF photolithography equipment. The biggest difference among them is the change from a transmissive structure to a reflective structure. In the EUV photolithography equipment, as both the EUV optical system and the EUV mask are changed to a reflective type, there is a disadvantage that light loss due to limited reflectance is very large.

Each of the mirrors constituting the EUV optics and the EUV mask has a theoretical maximum reflectance of about 70%, which means that a light loss of at least 30% is generated by each mirror.

It is reported that the EUV mirrors currently applied to EUV photolithography equipment have a reflectance of about 64% to 68%. In the photolithography equipment, at least 5 mirrors are used in the illumination system, and 6 mirrors are applied for projection, resulting in a total of 12 EUV mirrors including the EUV mask. This means that the light efficiency of the EUV optical system is less than 0.68¹² ~ 1%, and only about 1% of the generated light is used to transfer the pattern onto the wafer. This is quite inefficient, and as a result, the productivity of the EUV photolithography facility has come to be determined by the output of the light source.

Therefore, the semiconductor industry continuously requires the development of EUV photolithography equipment and methods to improve EUV light efficiency.

The maximum transmittance of conventional reflective projection optics is 12%, which is significantly lower than the 38% diffraction efficiency of a zone-plate lens. Specific limitations of the conventional reflective EUV system include, first, that the theoretical maximum reflectivity of the reflective EUV mirror and mask does not exceed 70%, causing significant light loss each time the light passes through an optical element, and second, that for a system including four mirrors in the illumination system, the theoretically achievable maximum overall transmittance is only about 25%.

### [Prior art Documents]

(Patent Document 1) KR Patent Registration No. 10-0582814
(Patent Document 2) KR Patent Registration No. 10-2056795
(Patent Document 3) EP Patent Publication No. 0969325
(Patent Document 4) US Patent Publication No. 08/824625
(Patent Document 5) KR Patent Publication No. 10-1999-0078346

### SUMMARY OF THE DISCLOSURE

### [Technical Problem]

The present invention, intended to solve the above-mentioned problems, aims to provide a transmissive EUV lithography device.

Another technical problem to be achieved in the present invention is to provide a high-efficiency EUV lithography device that applies a membrane-type diffractive optical element.

Furthermore, another technical problem to be achieved in the present invention is to provide a high-performance EUV lithography technology with high productivity by developing a 1-to-1 ratio exposure technology for the EUV mask and wafer pattern, along with the application of a transmissive EUV mask.

### [Solution to Problem]

To achieve the above objects, the present invention provides a lithography device, comprising: an EUV light source; a first membrane-type diffractive optical element that transmits EUV light output from the EUV light source to provide illumination light; a transmissive EUV mask that generates a pattern light to be patterned on a wafer with the EUV light transmitted through the first membrane-type diffractive optical element; and a second membrane-type diffractive optical element for exposing the wafer to the pattern light generated from the transmissive EUV mask.

In addition, the EUV light source is composed of an EUV light source with a wavelength of 13.5 nm generated by a plasma reaction through a Lithium or lithium alloy target.

In addition, the first membrane-type diffractive optical element and the second membrane-type diffractive optical element are zone-plate lenses.

In addition, the first membrane-type diffractive optical element and the second membrane-type diffractive optical element are composed of a single zone-plate lens array in which a plurality of zone-plate lenses are configured.

In addition, the first membrane-type diffractive optical element and the second membrane-type diffractive optical element are configured to have a thickness of less than 1 um.

In addition, the transmissive EUV mask is composed of a mask in which a fine pattern is formed with an absorber material on a membrane surface.

In addition, the first membrane-type diffractive optical element is configured with a fine pattern made of any one of Si, Si3N4, SiC, and Mo_xSi_y.

In addition, the second membrane-type diffractive optical element is configured with a fine pattern made of any one of Mo, a Mo_xSi_y multilayer structure, or Ru.

In addition, the EUV light source further comprises a collector mirror that collects EUV light generated from a Lithium or lithium alloy target.

In addition, the second membrane-type diffractive optical element irradiates the pattern light such that the transmissive EUV mask pattern is exposed onto the wafer at a 1:1 ratio.

In addition, the first membrane-type diffractive optical element and the second membrane-type diffractive optical element are characterized in that the zone-plate lenses constituting the zone-plate lens array are matched 1:1, respectively, so that the number and position of the arrays are identical.

In addition, an order sorting aperture is further included between the first membrane-type diffractive optical element and the transmissive EUV mask, and between the transmissive EUV mask and the second membrane-type diffractive optical element, respectively.

In addition, the EUV mask corresponds to a membrane-type mask having a transmittance of 90% to 99%.

In addition, the first membrane-type diffractive optical element and the second membrane-type diffractive optical element are composed of a membrane having a transmittance of 30% to 90% or more.

In addition, in the first membrane-type diffractive optical element and the second membrane-type diffractive optical element, a plurality of respectively provided zone-plate lenses are arranged on the same axis in the vertical direction.

### [Advantageous Effects of Invention]

The present invention, configured and operating as described above, can achieve high transmittance. Specifically, the present invention has the advantage of overcoming the spherical aberration problem of individual zone-plate lenses and securing a wide field of view (FOV) by using a zone-plate lens, which is used as a diffractive optical element, in the form of a zone-plate lens array. In addition, the present invention has the advantage that continuous photolithography is possible while moving the wafer between each lens, and by exposing the pattern of the EUV mask and the wafer at a 1-to-1 ratio, the size of the wafer patterning can be increased by 4 times (which increases the area by 16 times) compared to the conventional 4-to-1 exposure technology.

### BRIEF DESCRIPTION OF THE DRAWINGS

FIG. 1 is an overall configuration diagram of a transmissive EUV lithography device according to the present invention.
FIG. 2 is a configuration diagram of an EUV light source according to an embodiment of the transmissive EUV lithography device according to the present invention.
FIG. 3 is a detailed configuration diagram of the transmissive EUV lithography device according to the present invention.
FIG. 4 is a configuration diagram of a diffractive optical element of the transmissive EUV lithography device according to the present invention.
FIG. 5 is a configuration diagram according to an embodiment of the transmissive EUV lithography device according to the present invention.

### [Description of the Reference Numerals]

100: EUV light source
200: First membrane-type diffractive optical element
210: Zone-plate lens array
220: Zone-plate lens
300: Transmissive EUV mask
400: Second membrane-type diffractive optical element
410: Zone-plate lens array
420: Zone-plate lens
450: OSA (order sorting aperture)
500: Wafer

### DETAILED DESCRIPTION OF THE PREFERRED EMBODIMENTS

Hereinafter, a transmissive EUV lithography device according to the present invention will be described in detail with reference to the accompanying drawings.

The transmissive EUV lithography device according to the present invention comprises, in a lithography device: an EUV light source; a first membrane-type diffractive optical element that transmits EUV light output from the EUV light source to provide illumination light; a transmissive EUV mask that generates a pattern light to be patterned on a wafer with the EUV light transmitted through the first membrane-type diffractive optical element; and a second membrane-type diffractive optical element for exposing the wafer to the pattern light generated from the transmissive EUV mask.

The main technical objective of the transmissive EUV lithography device according to the present invention is to provide an exposure device with a transmissive structure by applying a diffractive optical element for illumination, a diffractive optical element for exposure, and a transmissive mask, and the transmissive lithography device of the present invention corresponds to an EUV exposure device.

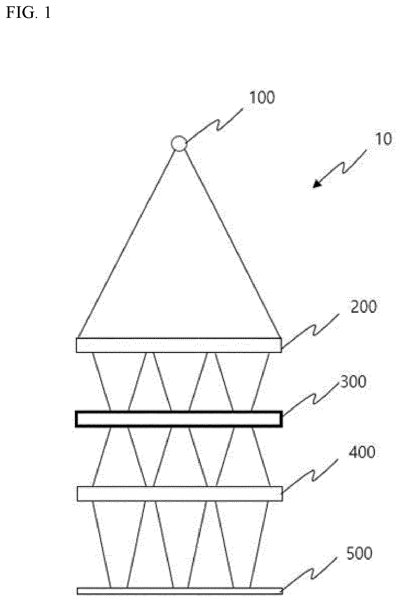

FIG. 1 shows an overall configuration diagram of a transmissive EUV lithography device according to the present invention.

The present invention provides this transmissive EUV lithography device (10) to achieve the technical problem described above.

The EUV exposure device is largely composed of five parts, which are an EUV light source (100), a first membrane-type diffractive optical element for illumination (200) to provide illumination light, a transmissive EUV mask (300), a second membrane-type diffractive optical element for exposure (400) that provides pattern light for exposure, and a wafer (500) coated with an EUV resist.

The lithography device according to the present invention may include a stage for the EUV mask (300) and a stage for the wafer so that the entire pattern of the mask can be scanned and exposed onto the wafer.

Therefore, the present invention is configured as an exposure device in which an EUV light source (100), a first membrane-type diffractive optical element (200), a transmissive EUV mask (300), a second membrane-type diffractive optical element (400), and a wafer (500) are sequentially arranged to implement EUV exposure with a transmissive structure.

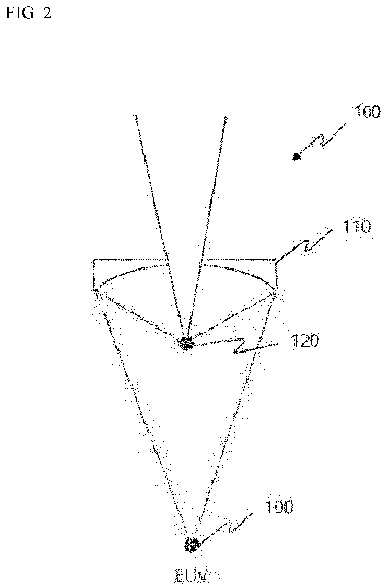

FIG. 2 is a detailed configuration diagram of the transmissive EUV lithography device according to the present invention.

The EUV light source (100) according to the present invention is preferably composed of an EUV light source with a wavelength of 13.5 nm generated by a plasma reaction through a Lithium or lithium alloy target.

The main advantage of applying an Li LPP or Li Alloy LPP light source instead of a conventional Sn LPP light source is that while the EUV light generated from Sn LPP has a relatively broad spectrum around 13.5 nm, the EUV light generated from Li or Li Alloy LPP has a very narrow linewidth with a center wavelength of 13.5 nm and a bandwidth of only about 0.0045 nm to 0.00675 nm.

EUV light generated from an Sn LPP light source is collected through an EUV mirror coated with a multilayer film. At this time, depending on the reflection spectrum characteristics of the multilayer coating used on the mirror, only light with a linewidth between about 0.3 nm and 0.5 nm is selected and passed through.

On the other hand, the Li LPP light source itself has a much narrower linewidth than this. Therefore, when using diffractive elements such as a zone-plate lens, which cause chromatic aberration, as optical elements, there is an advantage that the light can be applied immediately without an additional linewidth improvement device.

Ultimately, the Li LPP light source has a very narrow linewidth, making it very advantageous for applying a diffractive optical system. A linewidth of 0.00450 to 0.00675 nm corresponds to a lambda/delta lambda (λ/Δλ) value of about 2000 to 3000. If one tries to implement such a narrow linewidth by combining an Sn LPP light source and a monochromator, the proportion of light belonging to the λ/Δλ range of 2000 to 3000 out of the wide light spectrum around the 13.5 nm wavelength is very low, causing the light output to decrease sharply. On the other hand, since the Li LPP light source is a high spectral brightness light source with high light output within a narrow linewidth, there is no need to apply a separate monochromator to reduce the linewidth.

For a diffractive optical system such as the zone-plate lens, a light source with high spectral brightness (having high output within a narrow linewidth) like Li LPP is very effective.

In addition, the present invention further includes a collector mirror (110) to collect a high amount of light when generating EUV light using a Lithium or Lithium alloy target (120). This is because when a laser beam is irradiated onto the lithium or lithium alloy target, EUV light with a wavelength of 13.5 nm is emitted from the lithium plasma generated from the target.

The EUV light thus generated can be collected by a collector mirror (110) with a multilayer structure, or it can have a structure where it is directly transmitted from the plasma to the illuminator without passing through a collector mirror.

As such, the EUV light generated from the lithium or lithium alloy target used in the present invention is used as EUV light with high spectral brightness.

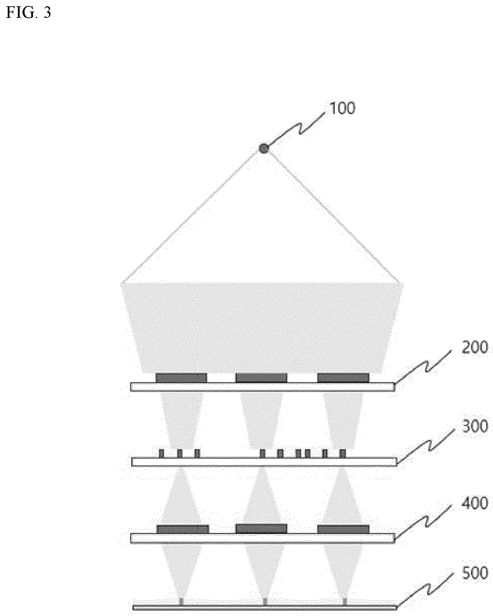

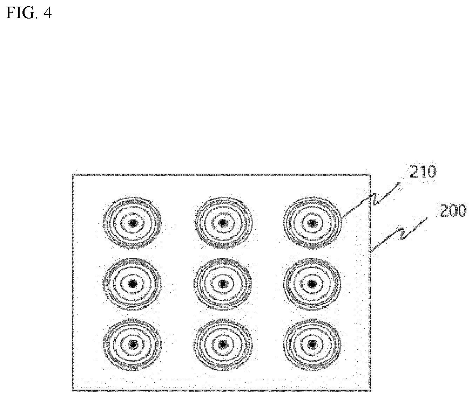

FIG. 3 is a configuration diagram of an EUV light source according to an embodiment of the transmissive EUV lithography device of the present invention, and FIG. 4 is a configuration diagram of a diffractive optical element of the transmissive EUV lithography device of the present invention.

The first membrane-type diffractive optical element (200) and the second membrane-type diffractive optical element (400) applied in the present invention are diffractive optical elements having a zone-plate lens array.

In addition, the first membrane-type diffractive optical element and the second membrane-type diffractive optical element are configured to have a thickness of less than 1 um to satisfy the transmission characteristics.

Specifically, the first membrane-type diffractive optical element (200) is configured with a fine pattern made of any one material from Si, Si3N4, SiC, and Mo_xSi_y. The second membrane-type diffractive optical element (400) is configured with a fine pattern made of any one of Mo, a Mo_xSi_y multilayer structure, or Ru.

Preferably, the first membrane-type diffractive optical element and the second membrane-type diffractive optical element are composed of a membrane having a transmittance of 38% or more.

At this time, for the first membrane-type diffractive optical element and the second membrane-type diffractive optical element, a membrane having a transmittance of 30% to 90% can also be used.

In addition, the transmissive EUV mask is a mask in which a fine pattern is formed with an absorber material on the membrane surface, and at this time, a preferable example of the absorber material is Ta or Ti.

Preferably, the EUV mask is a membrane-type mask having a transmittance of 90% or more. The EUV mask can use a membrane-type mask having a transmittance of 90% to 99%.

The transmissive EUV exposure system proposed in the present invention has the following features.

The transmissive EUV mask used for wafer patterning is fabricated by membrane technology and can theoretically have a transmittance ranging from 90% to 99%.

The zone-plate lens array used as a diffractive optical element in the present invention has a high diffraction efficiency of up to 38% and is used together with an Li LPP light source, which has excellent monochromatic light characteristics. In addition, by configuring the lens in an array form at this time, it is possible to overcome the limitation of spherical aberration that individual zone-plate lenses have, and at the same time, secure a wide field of view (FOV).

Of course, the diffraction efficiency of the zone-plate lens array used as a diffractive optical element is not limited to 38%, and higher efficiency can be achieved through technological improvements.

The specific structural advantages of the zone-plate lens array are as follows. First, the illumination lens and the exposure lens transfer the mask pattern to the wafer, and at this time, each lens is arranged at the same position on the vertical axis.

Second, this arrangement structure has the advantage of enabling continuous exposure while moving the wafer.

Due to this, the present invention can increase the size of the wafer patterning area by 4 times (increasing the area by 16 times) compared to the conventional 4-to-1 exposure technology, and secondly, it can significantly increase the number of transistors required for AI chip manufacturing, which is expected to provide a great advantage for future AI technology development.

The high efficiency of the transmissive EUV exposure system according to the present invention will be described in detail as follows.

First, the transmissive EUV mask (300) made through membrane technology can theoretically achieve a high transmittance of 90%.

In addition, the zone-plate lens array has a diffraction efficiency of up to 38%, and by using an Li LPP light source, a monochromatic light source can be applied.

In addition, such a zone-plate lens array can overcome the spherical aberration possessed by a zone-plate lens and secure a wide field of view (FOV).

In addition, the conventional EUV exposure apparatus, which consists of a combination of an Sn LPP light source and mirrors, uses 5 EUV mirrors for illumination and 6 EUV mirrors for exposure. And since a reflective EUV mask is used as the mask, a total of 12 EUV mirrors are used. Here, assuming that the reflectance of each mirror is 70%, which is close to the theoretical value (actually, the highest level is 68% to 69%), the total light transmittance of the system is 0.7¹², which is about 1.38%. In comparison, the transmittances of the illumination zone-plate lens array, the transmissive EUV mask, and the exposure zone-plate lens array constituting the present invention are 38%, 90%, and 38%, respectively. This means that the total light transmittance of the system is about 13%, which is about 10 times higher light transmittance efficiency compared to the 1.38% efficiency of the conventional reflective system composed of EUV mirrors. This means that the light efficiency is 10 times higher than the conventional one, which has the advantage of being able to reduce the required EUV light output to 1/10 or increase the exposure speed by 10 times.

The exposure magnification of the lithography device of the present invention configured as described above is 1X, whereas the conventional reflective exposure apparatus applies a 4:1 exposure magnification that reduces the size of the mask pattern to 1/4 on the wafer. Due to the physical mask size of 6 inches, the maximum chip size that can be formed on a wafer is limited to 6/4 inches. In reality, since the entire 6-inch mask surface cannot be used, the maximum chip size formed on the wafer corresponds to 26 mm x 33 mm.

However, the lithography device with 1X magnification according to the present invention exposes the pattern of the transmissive mask onto the wafer at a 1:1 ratio, thereby allowing the maximum chip size to be increased by 4 times compared to the conventional one, and as a result, the chip area can be increased by 16 times compared to the conventional one. This means that the number of transistors included in a large chip can be increased by 16 times, which has a very excellent advantage for the manufacturing of future semiconductors that require a large number of transistors, such as AI chips.

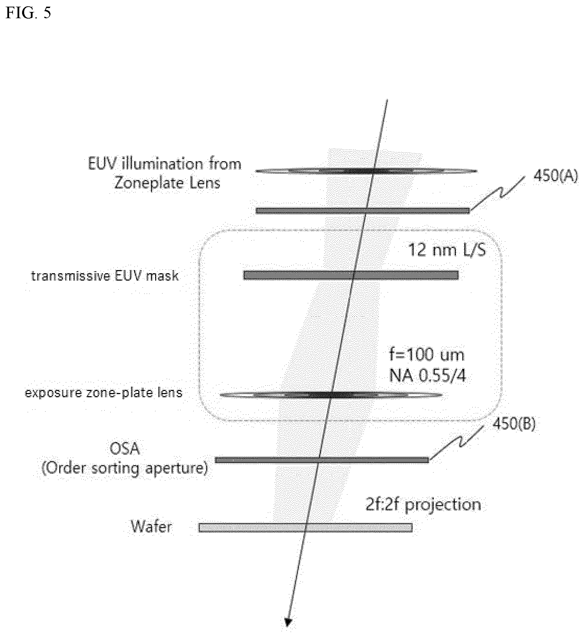

FIG. 5 is a configuration diagram according to an embodiment of the transmissive EUV lithography device of the present invention.

The EUV lithography device with a transmissive structure can greatly simplify the structure and can significantly improve the exposure area and exposure speed while resolving the structural complexity of the conventional reflective structure exposure device, thereby providing a very excellent lithography device for the next-generation semiconductor process.

Meanwhile, as another embodiment according to the present invention, an order sorting aperture (OSA; 450) may be further included between the second membrane-type diffractive optical element and the wafer.

The order sorting apertures (450A, 450B) serve to block light other than the first-order diffracted light generated from the illumination and exposure zone-plate lens arrays. The Order Sorting Aperture (OSA) can be installed at the next position of the illumination zone-plate lens (450(A)) and at the next position of the exposure zone-plate lens (450(B)), respectively.

The present invention, configured as described above, has the advantage of overcoming the chronic spherical aberration problem of individual lenses and simultaneously securing a wide field of view (FOV) by using a zone-plate lens in an array form.

In addition, the present invention has the advantage that continuous exposure is possible while moving the wafer between each lens, and by exposing the pattern of the EUV mask and the wafer at a 1-to-1 ratio, the size of possible wafer patterning can be increased by 4 times (which increases the area by 16 times) compared to the conventional 4-to-1 exposure technology.

While the present invention has been described and illustrated in connection with the preferred embodiments for illustrating the principles of the present invention, the present invention is not limited to the configuration and operation as shown and described. Rather, it will be well understood by those skilled in the art that numerous changes and modifications can be made to the present invention without departing from the spirit and scope of the appended claims. Therefore, all such appropriate changes, modifications, and equivalents should be considered to fall within the scope of the present invention.

## Claims

1. A transmissive EUV lithography device, comprising, in a lithography device:
an EUV light source;
a first membrane-type diffractive optical element that transmits EUV light output from the EUV light source to provide illumination light;
a transmissive EUV mask that generates a pattern light to be patterned on a wafer with the EUV light transmitted through the first membrane-type diffractive optical element; and
a second membrane-type diffractive optical element for exposing the wafer to the pattern light generated from the transmissive EUV mask.

2. The transmissive EUV lithography device of claim 1, wherein the EUV light source is composed of an EUV light source with a wavelength of 13.5 nm generated by a plasma reaction through a Lithium or lithium alloy target.

3. The transmissive EUV lithography device of claim 1, wherein the first membrane-type diffractive optical element and the second membrane-type diffractive optical element are composed of a zone-plate lens.

4. The transmissive EUV lithography device of claim 1, wherein the first membrane-type diffractive optical element and the second membrane-type diffractive optical element are composed of a single zone-plate lens array in which a plurality of zone-plate lenses are configured.

5. The transmissive EUV lithography device of claim 3, wherein the first membrane-type diffractive optical element and the second membrane-type diffractive optical element are configured to have a thickness of less than 1 um.

6. The transmissive EUV lithography device of claim 1, wherein the transmissive EUV mask is a mask in which a fine pattern is formed with an absorber material on a membrane surface.

7. The transmissive EUV lithography device of claim 3, wherein the first membrane-type diffractive optical element is configured with a fine pattern made of any one of Si, Si3N4, SiC, and Mo _xSi_y.

8. The transmissive EUV lithography device of claim 1, wherein the second membrane-type diffractive optical element is configured with a fine pattern made of any one of Mo, a Mo_xSi_y multilayer structure, and Ru.

9. The transmissive EUV lithography device of claim 1, wherein the EUV light source further comprises a collector mirror that collects EUV light generated from a Lithium or lithium alloy target.

10. The transmissive EUV lithography device of claim 2, wherein the second membrane-type diffractive optical element irradiates the pattern light such that the transmissive EUV mask pattern is exposed onto the wafer at a 1:1 ratio.

11. The transmissive EUV lithography device of claim 2, wherein the first membrane-type diffractive optical element and the second membrane-type diffractive optical element are **characterized in that** the zone-plate lenses constituting the zone-plate lens array are matched 1:1, respectively, so that the number and position of the arrays are identical.

12. The transmissive EUV lithography device of claim 1, wherein an order sorting aperture is further included between the first membrane-type diffractive optical element and the transmissive EUV mask, and between the transmissive EUV mask and the second membrane-type diffractive optical element, respectively.

13. The transmissive EUV lithography device of claim 1, wherein the EUV mask is a membrane-type mask having a transmittance of 90% to 99%.

14. The transmissive EUV lithography device of claim 1, wherein the first membrane-type diffractive optical element and the second membrane-type diffractive optical element are composed of a membrane having a transmittance of 30% to 90%.

15. The transmissive EUV lithography device of claim 1, wherein in the first membrane-type diffractive optical element and the second membrane-type diffractive optical element, a plurality of respectively provided zone-plate lenses are arranged on the same axis in the vertical direction.
